# DEMANDE DE BREVET EUROPEEN

(11) **EP 1 975 343 A1**
(43) Date de publication de la demande: **01.10.2008**
(21) Numéro de dépôt: 08103104.9
(22) Date de dépôt: 28.03.2008
(51) Int. Cl.: E04H 5/02

(54) **Structure d'un batiment destiné à héberger des données informatiques**

(30) Priorité: 30.03.2007 FR 0754192
(71) Demandeur: Data 4, 75008 Paris (FR)
(72) Inventeur: SERINET, Gilles, 92500, RUEIL MALMAISON (FR)
(74) Mandataire: Texier, Christian

(57) **Abrégé**

La présente invention concerne une structure d'un bâtiment (1) destiné à héberger des données informatiques, comprenant au moins une salle informatique (2) logeant des moyens de traitement informatique, au moins un local technique (5) comprenant des éléments techniques nécessaires au fonctionnement de la salle informatique (2), et au moins un couloir technique (3),
caractérisée en ce que la salle informatique (2) est située en périphérie du bâtiment (1), et en ce que le local technique (5) est situé au coeur dudit bâtiment (1).

## Description

L'invention concerne la structure des bâtiments destinés à loger des données informatiques.

On connaît de tels bâtiments sous le nom de « data centers » (pour centres de données), ou encore centre d'hébergement de données informatiques.

De tels centres comprennent généralement au moins une salle informatique logeant des moyens de traitement informatique, et au moins un local technique comprenant des moyens nécessaires au fonctionnement de la salle informatique. Le cas échéant, ces centres comprennent en outre des salles de réunion, des locaux de bureaux ou des zones conviviales.

Ils sont spécialement conçus pour héberger et protéger des équipements informatiques et équipements réseaux critiques. Pour les entreprises qui requièrent ce type de services, l'indisponibilité du site ou la perte de données peuvent se révéler très coûteuses. Ainsi les centres d'hébergement ont-ils tout particulièrement été conçus de manière à assurer une protection maximale des données informatiques hébergées.

Ainsi, l'architecture des bâtiments est telle que les salles informatiques sont situées au coeur du centre, pour garantir leur protection, tandis que les locaux techniques, comprenant notamment les batteries, onduleurs, les locaux opérateurs télécommunication et les groupes électrogènes, et les tableaux généraux basse tension sont agencés en périphérie. Par ailleurs, la structure est étudiée de manière à maintenir un haut niveau de services et de sécurité, dans le but d'assurer l'intégrité et le fonctionnement des éléments qui le composent.

Un objectif de l'invention est de proposer une nouvelle structure d'un centre d'hébergement de données informatiques permettant de protéger et de sécuriser au mieux les équipements informatiques et réseaux logés dans les salles informatiques.

Un autre objectif de l'invention est de proposer une nouvelle structure d'un centre d'hébergement de données informatiques qui soit modulaire.

Un autre objectif de l'invention est de proposer une nouvelle structure d'un centre d'hébergement de données informatiques plus fiable.

Un autre objectif de l'invention est de proposer une nouvelle structure d'un centre d'hébergement de données informatiques présentant une sécurité accrue.

Afin d'atteindre ces objectifs et de protéger au mieux les données informatiques stockées dans le centre d'hébergement de données informatiques, la structure du bâtiment a été repensée entièrement, de manière à garantir en priorité le fonctionnement du matériel informatique des salles data, quelles que soient les conditions extérieures.

Le Demandeur s'est en effet rendu compte que, lorsqu'un équipement informatique ou un équipement réseau, logé dans la salle, tombait en panne, pour quelque raison que ce soit, sa réparation ou son remplacement était réalisable et mis en oeuvre sans délai. Par ailleurs, il a remarqué que la panne d'un matériel informatique de la salle data n'entraînait pas le dysfonctionnement des autres, et donc que le centre d'hébergement pouvait poursuivre sa mission.

En revanche, le Demandeur s'est rendu compte que la panne d'un élément technique, tel qu'un groupe électrogène, un ensemble de batteries, ou encore un groupe froid, pouvait avoir des conséquences désastreuses sur le bon fonctionnement des salles data. En effet, sans alimentation énergétique, ou lorsque les réseaux de distribution sont coupés, les équipements ne peuvent être opérationnels. Et sans système de climatisation viable, l'augmentation inévitable de la température de la pièce, due à l'échauffement du matériel informatique, a des conséquences désastreuses sur le matériel et peut gravement l'endommager si elle dépasse une certaine limite.

Pourtant, le remplacement ou la réparation de tels éléments techniques est longue et difficile, et peut prendre plusieurs mois.

C'est pourquoi le Demandeur a-t-il réalisé une structure de bâtiment destiné à héberger des données informatiques, comprenant au moins une salle informatique logeant des moyens de traitement informatique, au moins un local technique comprenant des éléments techniques nécessaires au fonctionnement de la salle informatique, et au moins un couloir technique, caractérisée en ce que la salle informatique est située en périphérie du bâtiment, et en ce que le local technique est situé au coeur dudit bâtiment.

Certains aspects préférés mais non limitatifs sont les suivants :
- la salle informatique, le local technique et le couloir technique forment un bloc indépendant,
- le bloc comprend en outre une zone tertiaire, dans laquelle se trouve au moins une pièce parmi les suivantes: un bureau, une salle de réunion, ou une zone conviviale,
- le bloc est modulable,
- elle comprend au moins deux blocs indépendants,
- les deux blocs sont symétriques,
- le couloir technique est intercalé entre le local technique et la salle informatique,
- la salle informatique est en zone sèche,
- le couloir technique est en zone humide,
- le couloir technique comprend au moins une centrale de traitement d'air,
- le local technique comprend au moins un élément parmi le groupe suivant : groupe électrogène, groupe froid, batterie, onduleur, transformateur, opérateur de télécommunication ou tableau général basse tension,
- le groupe électrogène, le groupe froid, l'onduleur, le transformateur, l'opérateur de télécommunication et le tableau général basse tension sont chacun localisés dans un local technique spécifique séparé,
- chaque local technique spécifique est dédoublé au sein du bâtiment,
- le couloir technique véhicule l'eau froide provenant du local technique spécifique au groupe froid vers les centrales de traitement d'air,
- les zones accessibles à des opérateurs et les zones à vocation technique ont un accès séparé,
- la salle informatique est dépourvue d'éléments porteurs,
- la structure est en béton armé,
- l'arrivée du réseau d'énergie, la distribution d'énergie, la chaîne de distribution électrique dans son ensemble, à savoir notamment les tableaux génériques basse tension ou les onduleurs, la distribution des réseaux de données, les salles opérateurs, les groupes froids, et la distribution de l'eau glacée venant des groupes froids sont dédoublés,
- l'arrivée double des réseaux d'énergie est distincte,
- un contrôle d'accès est effectué au moins à l'entrée du bâtiment, à l'entrée du bloc, ou à l'entrée de la salle informatique,
- la structure comprend en outre un système de surveillance vidéo,
- la structure comprend en outre au moins un moyen parmi : un moyen de détection d'eau, un moyen de contrôle de l'hygrométrie, un moyen de détection d'incendie, une protection coupe-feu, un mur coupe-feu interne à la structure, un Réseau Incendie Armé (RIA), ou une réserve d'eau extérieure.

D'autres caractéristiques, buts et avantages de la présente invention apparaîtront à la lecture de la description détaillée qui va suivre, au regard des dessins annexés, donnés à titre d'exemples non limitatifs et sur lesquels :

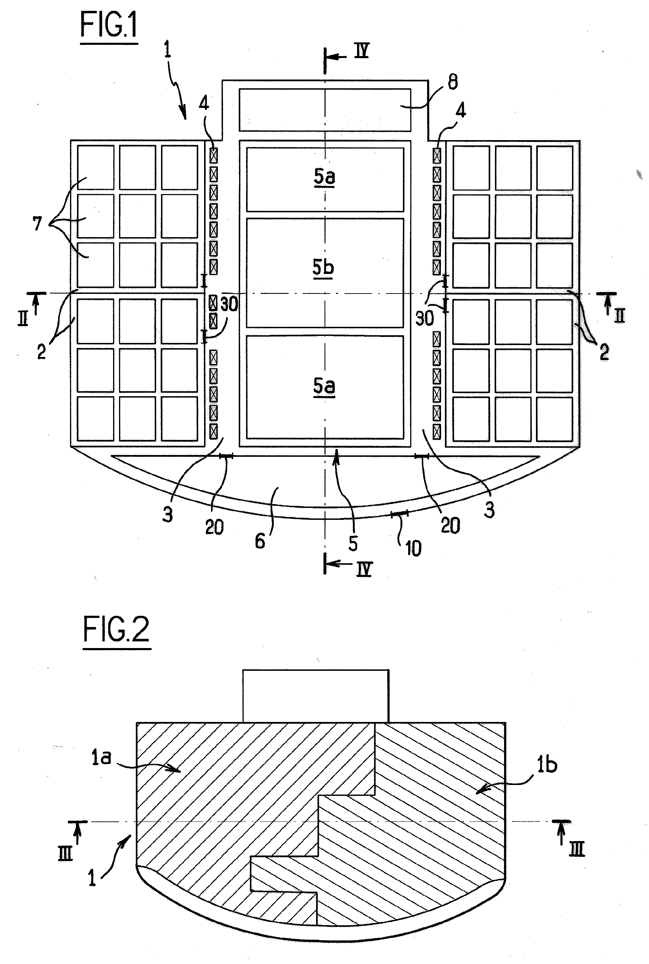

- La figure 1 est un plan de principe d'un étage d'un centre d'hébergement de données informatiques selon l'invention,
- La figure 2 est un plan de principe de deux blocs composant le centre d'hébergement de données informatiques selon l'invention,

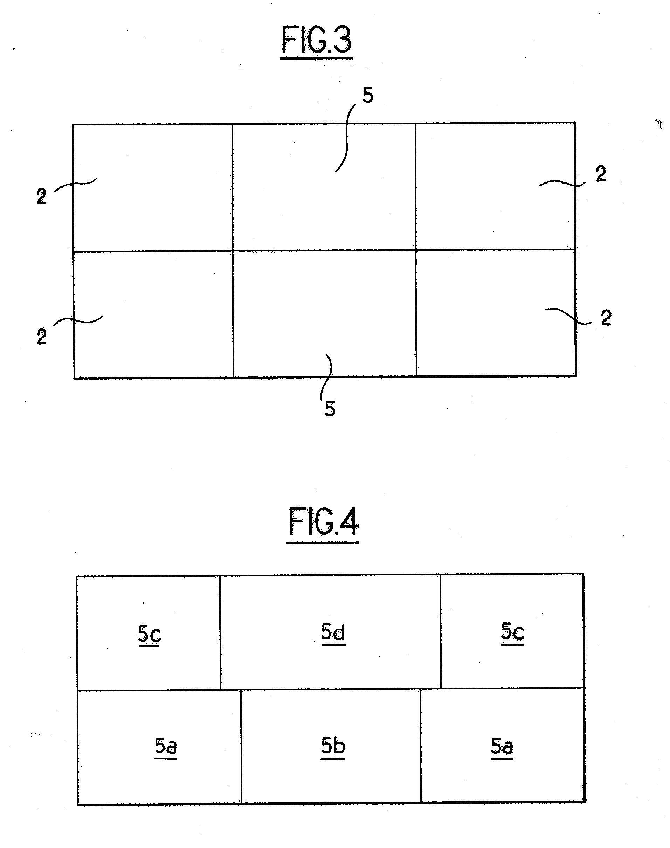

- La figure 3 est un plan en coupe transversale, selon la ligne III-III des figures 1 et 2, d'un centre d'hébergement de données informatiques selon l'invention, le centre ayant deux étages,
- La figure 4 est un plan en coupe longitudinale, selon la ligne IV-IV des figures 1 et 2, d'un centre d'hébergement de données informatiques selon l'invention, le centre ayant deux étages.

Le centre d'hébergement de données informatiques 1 selon l'invention est formé d'au moins un bloc comprenant :
- au moins une salle informatique (ou salle data) 2, de préférence plusieurs, qui héberge les équipement informatiques et/ou les équipements réseaux,
- au moins un couloir technique 3, rattaché à ces salles 2, où sont situés des centrales de climatisation 4,
- des locaux techniques 5 séparés, qui contiennent notamment des groupes froids, des groupes électrogènes 5b, des onduleurs 5a et des opérateurs de télécommunication, et
- au moins une zone tertiaire 6, comprenant bureaux, salles de réunion et zones conviviales.

De préférence, le centre 1 comprend deux blocs 1a et 1b identiques du type précité, totalement indépendants, et de taille modulable, de manière à être aisément adaptés aux besoins de chaque entreprise. Leur surface respective est par exemple de l'ordre de 1000 m². Chaque bloc peut être réservé à l'usage exclusif d'une entreprise.

Les pièces composant le centre d'hébergement 1 peuvent être réparties sur un seul étage ou plusieurs.

Les salles data 2 comprennent, par exemple, des serveurs empilés dans des racks 7, lesquels sont arrangés dans l'espace de manière à former des rangées simples afin de laisser la circulation libre entre eux. De préférence, le centre 1 comprend deux étages, de sorte que l'on puisse dimensionner aisément les salles 2 afin que la surface au sol soit la plus grande possible sans nécessiter d'éléments porteurs, par exemple grâce à des dalles alvéolaires de grande portée.

Les locaux techniques 5 sont alors répartis au coeur de chaque étage du bâtiment. Ils sont séparés les uns des autres, chacun étant spécifique à l'hébergement d'un type de composant technique parmi : les groupes électrogènes 5b, les batteries 5a, les onduleurs 5c, les transformateurs, les groupes froids, les opérateurs de télécommunication et les tableaux généraux. Ils sont placés au coeur de la structure du bâtiment, tandis que les salles data 2 sont situées en périphérie.

Les groupes froids sont de préférence placés en terrasse.

Les couloirs techniques 3 sont intercalés entre les salles datas 2 et les locaux techniques 5. Ils comprennent au moins une centrale de traitement d'air 4, relié au système de climatisation de la salle data 2. L'eau froide provenant des groupes froids, qui sont situés au coeur de la structure dans un local technique séparé, est véhiculée par les couloirs 3 vers des centrales de climatisation 4, qui envoient alors l'air refroidi au système de climatisation grâce à des souffleries.

Grâce à cette séparation des éléments techniques, à savoir ici les centrales de traitement d'air 4 et les groupes froids, seuls les couloirs techniques 3 sont en zone humide, tandis que les salles data 2 restent en zone sèche en ne recevant que des fluides gazeux. Cette mesure garantit ainsi une protection des matériels de la salle data 2 contre d'éventuelles fuites d'eau.

Par ailleurs, les pièces du bâtiment sont agencées de telle sorte que les zones 6 accessibles aux opérateurs et les zones 8 à vocation technique ont un accès séparé. Par exemple, les opérations techniques de livraison et de maintenance sont effectuées par la façade arrière du bâtiment, tandis que les salles de travail, qui ont une visibilité sur les espaces d'hébergement, les bureaux et les zones conviviales sont situés en face avant. Ainsi, les accès aux salles data 2 par les opérateurs de maintenance sont limités au strict nécessaire, ce qui assure efficacité et sécurité.

En outre, pour garantir la fiabilité des services du centre d'hébergement 1 et son autonomie énergétique, on prévoit une redondance de la plupart des éléments techniques le constituant. Ainsi, le centre d'hébergement 1 comprend :
- une double arrivée distincte des réseaux d'énergie (Haute Tension),
- une distribution d'énergie dupliquée systématiquement pour chaque matériel électrique,
- une chaîne de distribution électrique dupliquée dans son ensemble :
   TGBT (pour Tableaux Générique Basse Tension), onduleurs, etc.
- une double adduction de chaque bâtiment,
- une distribution des réseaux de données dupliquée,
- des salles opérateurs avec adductions doublées et séparées,
- deux chaînes électriques indépendantes,
- des groupes froids en redondance,
- un surnombre des centrales de traitement d'air, assurant le fonctionnement du système de climatisation et le maintien des salles data à une température seuil malgré une perte de 50% des équipements,
- une possibilité de croisement des réseaux des groupes froid d'un bloc avec le groupe froid du bloc adjacent, afin d'alimenter en eau glacée les centrales de climatisation du groupe froid adjacent en cas de besoin, et
- une distribution de l'eau glacée venant des groupes froids dupliquée.

Par ailleurs, on prévoit également une alimentation de secours par des groupes électrogènes ayant une grande autonomie (par exemple, de l'ordre de 72 heures), et dont la puissance permet de secourir l'ensemble du bâtiment.

Concernant la sécurité du centre d'hébergement 1, la structure du bâtiment est agencée de sorte que l'accès soit contrôlé à au moins trois niveaux : à l'entrée 10 du centre grâce à une enceinte autour du bâtiment, à l'entrée 20 de chaque bloc, et à l'entrée 30 de chaque salle data. Le contrôle des accès est doublé d'un suivi et d'une surveillance vidéo.

De plus, afin de protéger les installations, on prévoit notamment des moyens de détection d'eau, des moyens de contrôle de l'hygrométrie, des moyens de détection d'incendie (par exemple par une double détection ionique et VESDA - pour Very Early Smoke Detection Alarm, c'est-à-dire un système de détection d'incendie par analyse de particules), des protections coupe-feu ainsi que des murs coupe-feu deux heures entre les divers locaux, une structure entière en béton armé (formant une coque de protection contre les agressions extérieures, et résistant au feu), un Réseau Incendie Armé (RIA), ou encore une réserve d'eau proche des bâtiments.

## Revendications

1. Structure d'un bâtiment (1) destiné à héberger des données informatiques, comprenant au moins une salle informatique (2) logeant des moyens de traitement informatique, au moins un local technique (5) comprenant des éléments techniques nécessaires au fonctionnement de la salle informatique (2), et au moins un couloir technique (3),
**caractérisée en ce que** la salle informatique (2) est située en périphérie du bâtiment (1), et **en ce que** le local technique (5) est situé au coeur dudit bâtiment (1).

2. Structure d'un bâtiment (1) selon la revendication précédente,
**caractérisée en ce que** la salle informatique (2), le local technique (5) et le couloir technique (3) forment un bloc (1a, 1 b) indépendant.

3. Structure d'un bâtiment (1) selon la revendication précédente,
**caractérisée en ce que** le bloc comprend en outre une zone tertiaire (6), dans laquelle se trouve au moins une pièce parmi les suivantes: un bureau, une salle de réunion, ou une zone conviviale.

4. Structure d'un bâtiment (1) selon l'une des revendications 2 ou 3,
**caractérisée en ce que** le bloc (1a, 1 b) est modulable.

5. Structure d'un bâtiment (1) selon l'une des revendications 2 à 4,
**caractérisée en ce qu'**elle comprend au moins deux blocs (1a, 1b) indépendants.

6. Structure d'un bâtiment (1) selon la revendication précédente,
**caractérisée en ce que** les deux blocs (1a, 1 b) sont symétriques.

7. Structure d'un bâtiment selon l'une des revendications précédentes,
**caractérisée en ce que** le couloir technique (3) est intercalé entre le local technique (5) et la salle informatique (2).

8. Structure d'un bâtiment (1) selon l'une des revendications précédentes, **caractérisée en ce que** la salle informatique (2) est en zone sèche.

9. Structure d'un bâtiment (1) selon l'une des revendications précédentes, **caractérisée en ce que** le couloir technique (3) est en zone humide.

10. Structure d'un bâtiment (1) selon l'une des revendications précédentes, **caractérisée en ce que** le couloir technique (3) comprend au moins une centrale de traitement d'air (4).

11. Structure d'un bâtiment (1) selon l'une des revendications précédentes, **caractérisée en ce que** le local technique (5) comprend au moins un élément parmi le groupe suivant : groupe électrogène, groupe froid, batterie, onduleur, transformateur, opérateur de télécommunication ou tableau général basse tension.

12. Structure d'un bâtiment (1) selon la revendication précédente,
**caractérisé en ce que** le groupe électrogène, le groupe froid, l'onduleur, le transformateur, l'opérateur de télécommunication et le tableau général basse tension sont chacun localisés dans un local technique spécifique séparé.

13. Structure d'un bâtiment (1) selon la revendication précédente,
**caractérisée en ce que** chaque local technique spécifique est dédoublé au sein du bâtiment (1).

14. Structure d'un bâtiment (1) selon l'une des revendications précédentes, en combinaison avec les revendications 10 et 12, **caractérisé en ce que** le couloir technique (3) véhicule l'eau froide provenant du local technique spécifique au groupe froid vers les centrales de traitement d'air (4).

15. Structure d'un bâtiment (1) selon l'une des revendications précédentes, **caractérisée en ce que** les zones (6) accessibles à des opérateurs et les zones (8) à vocation technique ont un accès séparé.

16. Structure d'un bâtiment (1) selon l'une des revendications précédentes, **caractérisée en ce que** la salle informatique (2) est dépourvue d'éléments porteurs.

17. Structure d'un bâtiment (1) selon l'une des revendications précédentes, **caractérisée en ce qu'**elle est en béton armé.

18. Structure d'un bâtiment (1) selon l'une des revendications précédentes, **caractérisée en ce que**
• l'arrivée du réseau d'énergie,
• la distribution d'énergie,
• la chaîne de distribution électrique dans son ensemble, à savoir notamment les tableaux généraux basse tension ou les onduleurs,
• la distribution des réseaux de données,
• les salles opérateurs,
• les groupes froids, et
• la distribution de l'eau glacée venant des groupes froids, sont dédoublés.

19. Structure d'un bâtiment (1) selon la revendication précédente,
**caractérisée en ce que** l'arrivée double des réseaux d'énergie est distincte.

20. Structure d'un bâtiment (1) selon l'une des revendications 2 à 19,
**caractérisée en ce qu'**un contrôle d'accès est effectué au moins à l'entrée (10) du bâtiment, à l'entrée (20) du bloc, ou à l'entrée (30) de la salle informatique (2).

21. Structure d'un bâtiment (1) selon l'une des revendications précédentes, **caractérisée en ce qu'**elle comprend en outre un système de surveillance vidéo.

22. Structure d'un bâtiment (1) selon l'une des revendications précédentes, **caractérisée en ce qu'**elle comprend en outre au moins un moyen parmi : un moyen de détection d'eau, un moyen de contrôle de l'hygrométrie, un moyen de détection d'incendie, une protection coupe-feu, un mur coupe-feu interne à la structure, un Réseau Incendie Armé (RIA), ou une réserve d'eau extérieure.
